# EUROPEAN PATENT APPLICATION

(11) **EP 2 919 385 A1**
(43) Date of publication of application: **16.09.2015**
(21) Application number: 13853586.9
(22) Date of filing: 18.07.2013
(51) Int. Cl.: H03F 3/181, G10H 3/00, G10D 1/00, G10H 1/32, B65D 53/00, H03F 99/00, G10H 3/18, G10D 3/00

(54) **PORTABLE SOUND DEVICE FOR AMPLIFYING SOUND FROM STRINGED MUSICAL INSTRUMENTS AND THE LIKE**

(30) Priority: 08.11.2012 BR 102012028587
(71) Applicant: Biancardini, Marcus Reis Esselin, Goiania - GO 74.115-060 (BR)
(72) Inventor: Biancardini, Marcus Reis Esselin, Goiania - GO 74.115-060 (BR)
(74) Representative: Sahuquillo Huerta, Jesús
(86) International application number: PCT/BR2013/000268
(87) International publication number: WO 2014/071474

(57) **Abstract**

"PORTABLE SOUND DEVICE FOR SOUND AMPLIFICATION OF STRING INSTRUMENTS AND SIMILAR MUSICAL INSTRUMENTS" the present invention refers to a type of acoustic and amplified Sound Box consisting of a Portable sound device (01), an Acoustic box (02) with a Flexible base (03) and Perforated sound outlet (07), internally containing the operating devices such as a PCI amplifier board, a Power battery (05), Loudspeaker sound amplifiers (06), subwoofer (08), Audio input and output connectors (09 and 10) as well as On/Off connector (11) with LED light, as well as P10 Plug (12) or similar installed on the lower part and Connector (13) for smartphones such as Iphone or Ipod or similar and/or USB Connector (14), to be used in amplifying sound in string instruments or similar instruments in order to provide sound amplification from the musical instrument whose primary sound source is the vibration of the tensioned strings when plucked, struck or rubbed and, thereby providing greater surround sound and better quality, reaching a more distant audience and not only those close to the musician and his instrument.

## Description

The present invention refers to a type of acoustic and amplified Sound Box, consisting of a Portable Sound Device to amplify sound in string instruments and similar instruments, which is attached to these through "PIO" Plug to amplify sound coming from the musical instrument whose primary sound source is the vibration of tensioned strings when plucked, struck or rubbed, thereby providing a greater surround sound and better quality, reaching a more distant audience and not only those close to the musician and his instrument, since these instruments naturally have low sound volume produced by the vibration of the string when activated in most string instruments.

Due to their low sound volume produced by the vibration of the string, some string instruments are known to have pre-amplifier plugged to Sound boxes through cables or wireless transmitters because without this they cannot produce sounds able to cover a large distance, especially outdoors, and there is no knowledge of any portable equipment able to be plugged directly to the string instrument in order to immediately amplify a sound anywhere, which is a problem during the use of instruments in open or closed environments, expecting to reach a large audience.

Therefore, the present invention was developed with the purpose of solving this problem and difficulty, which will be better understood in the aid of the figures attached, where:

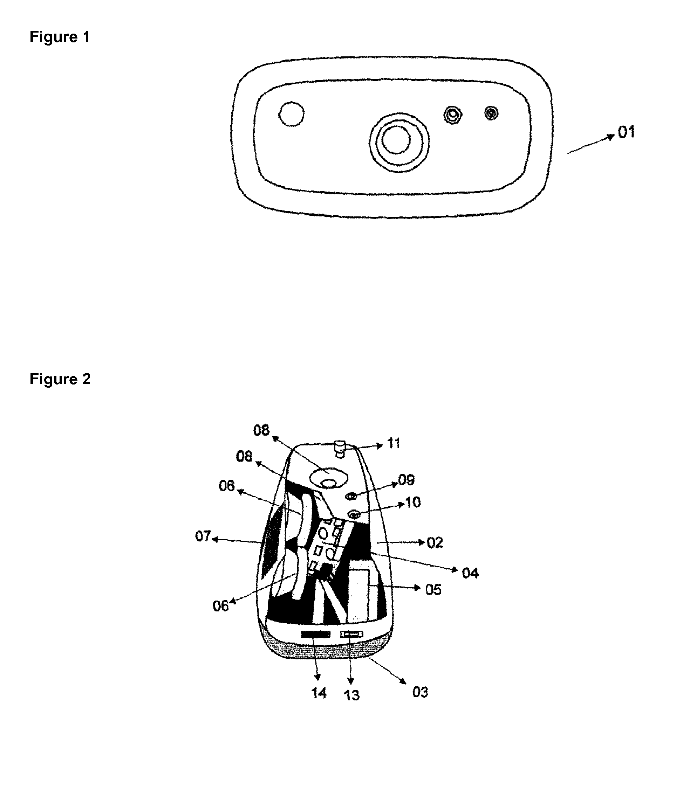

**Figure 1** shows the Portable sound device with top view.
**Figure 2** shows the portable sound device with perspective side view, with a section that enables internal visualization.

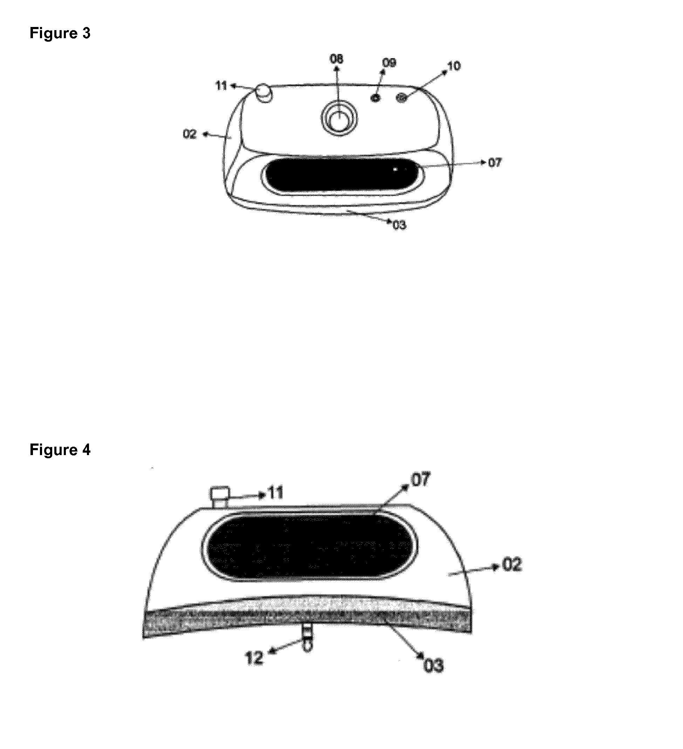

**Figure 3** shows the Portable sound device with perspective front view.
**Figure 4** shows the Portable sound device with anterior side view.

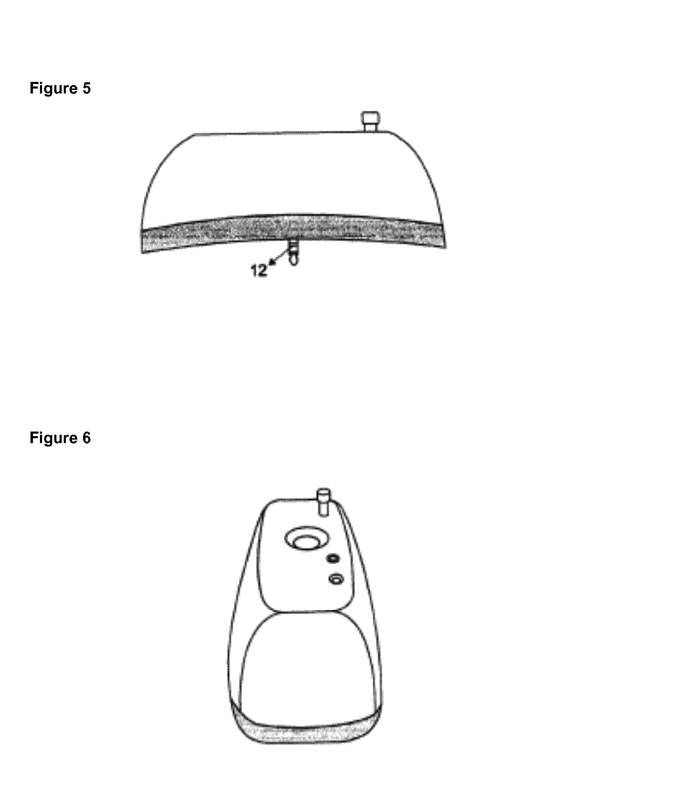

**Figure 5** shows the Portable sound device with posterior side view.
**Figure 6** shows the Portable sound device with the same view of Figure 2, but without section.

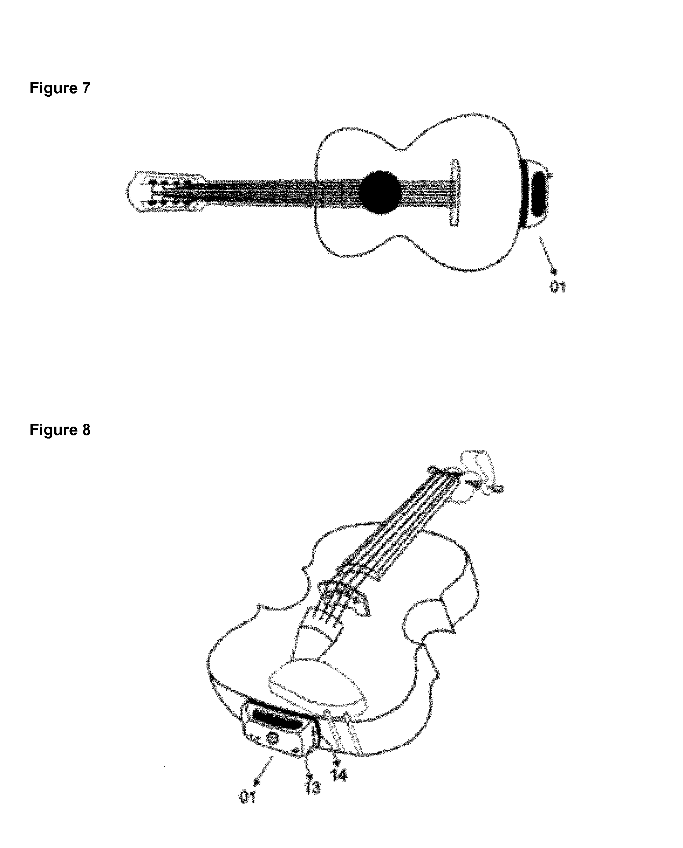

**Figure 7** illustrates the attachment of the Portable sound device to a string instrument model.
**Figure 8** illustrates the attachment of the Portable sound device to a second string instrument model.

According to the figures attached, we have: The Portable Sound Device (01) consists of an Acoustic box (02) equipped with a Flexible base (03) and Perforated sound output (07), internally containing the operating devices such as an PCI Amplifier board (04), a Power battery (05), Loudspeaker sound amplifiers (06), Subwoofer (08), Audio input and output connectors (09 and 10) as well as On/Off connector (11) with LED light, as well as P10 plug (12) or similar installed on the lower part and Connector (13) for smartphones such as Iphone or Ipod or similar and/or USB connector (14).

Therefore, this Portable Sound Device (01) can have its acoustic box (02) made in plastic or similar material so that its lower part provided by a flexible base (03) is coupled to the back or side of the string instrument through "P10" Plug or similar plug.

The Power battery (05) used is lithium or similar according to technological development, thereby providing greater duration, besides being rechargeable, including electronically through the USB port (14) or electric socket plug.

In addition to managing the electric power supply from the Battery (05), the PCI amplifier board (04) will also be responsible for interconnecting the internal devices, converting the electric signal into sound waves, amplifying these sound waves and carrying them through loudspeaker Sound Amplifiers (06) and Subwoofer (08), these in turn can be assembled at various powers, always observing the storage capacity of the Acoustic box (02) and also the amplification capacity of the said Amplifier board (04).

The Connectors (13 and 14) can also be used for sound input as pre-recorded follow-up bases, to enable the follow-up of the musician during handling of the musical instrument. Therefore, this Portable Sound Device (01) can be made in different powers and with various sizes, observing the configuration of the string instrument for which it is used, such as Viola, Box Guitar, Electric Guitar, Bass Guitar and others, and the P10 Plug (12) is inserted in the pre-amplifying devices already installed in the musical instruments and, in the case where any instrument does not have the said pre-amplifying device and, not wanting to install it so as not to perforate the instrument, the pre-amplifying mix can be inserted in the Sound box (01) and a tiny hole can be made on the instrument to install the female Plug or pass out a contact wire from inside the instrument, which will contain the said female Plug in order to introduce the P10 Plug (12).

## Claims

1. PORTABLE SOUND DEVICE FOR SOUND AMPLIFICATION OF STRING INSTRUMENTS AND SIMILAR MUSICAL INSTRUMENTS", which is **Characterized by** consisting of a Portable Sound Device (01) in which an Acoustic box (02) is used equipped with a Flexible base (03) and Perforated sound output (07), internally containing the operating devices such as an PCI Amplifier board (04), a Power battery (05), Loudspeaker sound amplifiers (06), Subwoofer (08), Audio input and output connectors (09 and 10) as well as On/Off connector (11) with LED light, as well as P10 plug (10) or similar installed on the lower part and Connector (13) for smartphones such as Iphone or Ipod or similar and/or USB connector (14).

2. "PORTABLE SOUND DEVICE FOR SOUND AMPLIFICATION OF STRING INSTRUMENTS AND SIMILAR MUSICAL INSTRUMENTS", according to Claim 1, is also **Characterized by** PCI Amplifier board (04) managing the electric power supply of the said Battery (05) and also converting the electric signal into sound waves, amplifying them and carrying them through the sound Amplifiers (06) and Subwoofer (08).

3. "PORTABLE SOUND DEVICE FOR SOUND AMPLIFICATION OF STRING INSTRUMENTS AND SIMILAR MUSICAL INSTRUMENTS", according to Claim 1, is also **Characterized by** the fact that the Sound Amplifiers (06) and Subwoofer (08) can be of various powers, always observing the storage capacity of the Acoustic Box (02) and also the amplifying capacity of the said Amplifier board (04).

4. "PORTABLE SOUND DEVICE FOR SOUND AMPLIFICATION OF STRING INSTRUMENTS AND SIMILAR MUSICAL INSTRUMENTS", according to Claims 1 to 3, is also **Characterized by** the fact that this Portable Sound Device (01) can be made in different powers and with different sizes, observing the configuration of the string instrument for which it is used, such as Viola, Box Guitar, Electric Guitar, Bass Guitar and others.
